Europäisches Patentamt

European Patent Office

Office européen des brevets

(19)

(11) Veröffentlichungsnummer : **0 371 252 B1**

(12) # EUROPÄISCHE PATENTSCHRIFT

(45) Veröffentlichungstag der Patentschrift :
16.09.92 Patentblatt 92/38

(51) Int. Cl.$^5$ : **C23G 5/00, C23C 14/02**

(21) Anmeldenummer : **89119683.4**

(22) Anmeldetag : **24.10.89**

(54) **Verfahren und Vorrichtung zum Ätzen von Substraten mit einer magnetfeldunterstützten Niederdruck-Entladung.**

(30) Priorität : **04.11.88 DE 3837487**

(43) Veröffentlichungstag der Anmeldung :
**06.06.90 Patentblatt 90/23**

(45) Bekanntmachung des Hinweises auf die
Patenterteilung :
**16.09.92 Patentblatt 92/38**

(84) Benannte Vertragsstaaten :
**AT BE CH DE ES FR GB IT LI LU NL SE**

(56) Entgegenhaltungen :
**DE-A- 3 442 208
GB-A- 2 093 866
GB-A- 2 170 226
SOVIET INVENTIONS ILLUSTRATED, Woche
8650, mekanische Sektion, Zusammenfassung
Nr. M-331189, M13, Seite 19, DerwentPublications Ltd, London, GB; & SU-A-1 227 280
(MAGM. MINE METALS INS.) 30-04-1986**

(73) Patentinhaber : **LEYBOLD
AKTIENGESELLSCHAFT
Wilhelm-Rohn-Strasse 25, Postfach 1555
W-6450 Hanau am Main 1 (DE)**

(72) Erfinder : **Hofmann, Dieter, Dipl.-Ing.
Kinzigheimer Weg 7
W-6454 Bruchköbel (DE)**
Erfinder : **Hensel, Bernd, Dipl.-Ing.
Königsteinerstrasse 108
W-6230 Frankfurt/Main 80 (DE)**

(74) Vertreter : **Zapfe, Hans, Dipl.-Ing.
Am Eichwald 7, Postfach 20 01 51
W-6056 Heusenstamm 2 (Rembrücken) (DE)**

EP 0 371 252 B1

EP 0 371 252 B1

## Beschreibung

Die Erfindung betrifft ein Verfahren zum Ätzen von Substraten mit einer magnetfeldunterstützten Niederdruck-Entladung. Das Ätzen geschieht dabei zur Vorbehandlung der Substrate für eine nachfolgende Beschichtung. Es geht dabei insbesondere um die Vorbehandlung metallischer Substrate bei der Herstellung von Schneidwerkzeugen, die geschliffene Schneidkanten aufweisen. Das Ätzen dient dabei zum Abtragen von Oxidhäuten und korrosiven Ablagerungen, und zwar soweit, bis ein sauberer metallischer Grundwerkstoff erreicht wird.

Derartige Ätzprozesse sind - auch als Vorbehandlungsstufe für die Beschichtung von Schneidwerkzeugen mit sogenannten Hartstoffen - grundsätzlich bekannt. Man hat sich dabei bei einer Doppelkatoden-Anordnung nach der DE-OS 31 07 914 so beholfen, daß man die Substrate während der Ätzphase zwischen den Katoden angeordnet und auf einer Ätzspannung von etwa -1000 V gehalten hat, wobei die Katoden ein Hilfsplasma zur Verfügung stellten. Hierbei werden die für die spätere Beschichtung vorgesehenen Targets der Katoden verunreinigt, so daß diese vor dem Beschichtungsvorgang wieder gegen eine Blende freigesputtert werden müssen. Eine solche Maßnahme ist in der DE-OS 34 42 208 beschrieben.

Mit den bekannten Verfahren und Vorrichtungen ist jedoch nur die Einstellung einer geringen Ätzrate möglich, die einer Stromdichte von weniger als 1 mA pro Quadratzentimeter Substratoberfläche entspricht. Hierbei ist der Ätzprozess außerordentlich zeitraubend, und zudem findet bei scharfen Schneiden und spitzen Kantengeometrien bei Werkzeugen aus HSS-Stählen leicht eine Kantenschädigung statt.

Beim Ätzen nach dem Stand der Technik müssen zwei einander diametral entgegenstehende Verfahrensbedingungen beachtet werden: Eine hohe Leistungsdichte pro Quadratzentimeter Substratoberfläche führt zu einer wünschenswert starken Aufheizung der Substrate. Substrattemperaturen von etwa 400 bis 500°C sind für die Ausbildung harter und haftfester Hartstoffschichten auf HSS-Stählen unerläßlich. Bei einer entsprechenden Leistungsdichte und unter Einsatz der hierfür erforderlichen hohen Substratpotentiale von negativ mehr als 1000 V erfolgt jedoch oft eine Beschädigung der Schneidkanten und damit eine Beeinträchtigung der Funktion der zu beschichtenden Werkzeuge. Setzt man die Ätzrate durch entsprechende Verrringerung der Leistungsdichte herab, so ergibt sich die bereits genannte entsprechend lange Ätzdauer und eine starke Ungleichmäßigkeit der Ätzwirkung an den zu ätzenden Teilen. Mit anderen Worten: Es findet an schwer zugänglichen Stellen der Teilegeometrie keine Ätzung statt, und die nachfolgend aufgebrachte Schicht leidet unter ungenügender Haftung. Außerdem kann die gewünschte Substrattemperatur nicht erreicht bzw. nicht eingehalten werden, sodaß ein Kompromiß zwischen einer ausreichend hohen Ätzrate und einer möglichst geringen Kantenschädigung und einer ausreichenden Haftung gefunden werden muß.

Dieser Kompromiß kann mit den Verfahren nach dem Stande der Technik nicht erreicht werden.

Komplizierte Substratgeometrien setzen ein gewisses Eindringvermögen des Plasmas in enge oder gar hinterschnittene Zwischenräume voraus. Die gleichen Überlegungen gelten für das Eindringen des Plasmas in Zwischenräume zwischen den zu ätzenden Teilen. In diesem Zusammenhang spielt der Begriff des "Dunkelraumabstandes" eine Rolle. Die Größe des Dunkelraumabstandes ist abhängig von der Potentialdifferenz zwischen Plasma und Substrat und umgekehrt proportional der Stromdichte am Substrat. Bei hoher Potentialdifferenz und geringer Stromdichte, wie sie beim konventionellen Ätzprozess üblich sind, treten Dunkelraumabstände von einigen Millimetern auf, während bei den erfindungsgemäß möglichen niedrigeren Potentialdifferenzen und hohen Stromdichten Dunkelraumabstände von weniger als einem Millimeter ermöglicht werden. Unter einer solchen Voraussetzung kann das Plasma sehr viel leichter in die Teilegeometrie eindringen, wodurch über die gesamte Oberfläche kompliziert geformter Teile ein gleichmäßigerer Ätzprozess erzielt wird.

Außerdem wird ein Re-Depositionsprozeß vermieden, d.h. es wird unterdrückt, daß Teilchen von bevorzugt ätzbaren Oberflächenteilen wie Schneiden und Kanten auf schlecht zugänglichen Oberflächenteilen wie z.B. Spannuten kondensieren und dort nicht mehr abgetragen werden können, sodaß sie für den nachfolgenden Beschichtungsprozeß von vorne herein zu schlechten Haftbedingungen führen.

Der Erfindung liegt daher die Aufgabe zugrunde, ein Ätzverfahren der eingangs beschriebenen Gattung anzugeben, mit dem eine ausreichend hohe Ätzrate bei gleichmäßiger Oberflächenbehandlung und unter sehr weitgehender Schonung vorspringender Kanten möglich ist. Weiterhin sollen die Substrate durch das Ätzverfahren auf einer ausreichend hohen Temperatur gehalten bzw. gebracht werden.

Die Lösung der gestellten Aufgabe erfolgt bei dem eingangs beschriebenen Verfahren erfindungsgemäß dadurch, daß

a) das Magnetfeld derart von den Substraten entkoppelt ist, daß die magnetische Feldstärke im Substratbereich kleiner als 6000 A/m ist,

b) in dem Raum zwischen den Substraten und dem Magnetsystem mindestens ein Elektronen-Emitter an einer Stelle angeordnet ist, an der eine magnetische Feldstärke vorhanden ist, die größer ist als die Felds-

2

tärke im Bereich der Substrate aber kleiner oder gleich 12000 A/m,

c) auf der dem mindestens einen Elektronen-Emitter abgekehrten Seite der Substrate mindestens eine Anode mit einem Anodenpotential von +10 bis +250 V gegenüber Masse angeordnet ist,

d) an die Substrate ein Ätzpotential zwischen -100 V und -1000 V gegenüber Masse angelegt ist,

e) das Verhältnis der Zwischenräume zwischen den Substraten und den Projektionsflächen der Substrate auf eine durch die Zwischenreäume hindurchgeführte Projektionsebene mindestens 0,1 beträgt,

f) die Potentialdifferenz zwischen dem mindestens einen Emitter und der mindestens einen Anode so hoch gewählt wird, daß vom Emitter durch die Substratzwischenräume hindurch bis zur Anode ein Elektronenstrom (Primär- und Sekundärelektronen) fließt.

Die erfindungsgemäß zu wählenden magnetischen Feldstärken sind dabei deutlich kleiner als diejenigen Feldstärken, die bei vergleichbaren geometrischen Verhältnissen bei Magnetron-Katoden auftreten, die für Beschichtungszwecke, d. h. für die Zerstäubung eines Targets, verwendet werden. Man kann die erfindungsgemäße Anpassung der magnetischen Feldstärke auf zweierlei Weise vornehmen: Entweder verändert man die Entfernung der Substrate und des Elektronen-Emitters vom Magnetfeld, oder man verwendet Magnetfelderzeuger mit entsprechend verringerter Feldstärke. Selbstverständlich können auch beide Maßnahmen gleichzeitig angewandt werden. Bei Verwendung von Permanentmagneten für die Magnetfelderzeuger werden bevorzugt Magnetwerkstoffe mit einer von Haus aus geringeren Feldstärke eingesetzt. Bei Verwendung von Elektromagneten läßt sich die Feldstärke durch den Erregerstrom beeinflussen.

Aber auch die erfindungsgemäßen Potentialverhältnisse von Elektronen-Emitter, Substraten und Anoden, tragen entscheidend dazu bei, daß mittels einer Anordnung, die mit anderen Verfahrensparametern eine Beschichtungsvorrichtung darstellt, ein Ätzprozess durchgeführt werden kann.

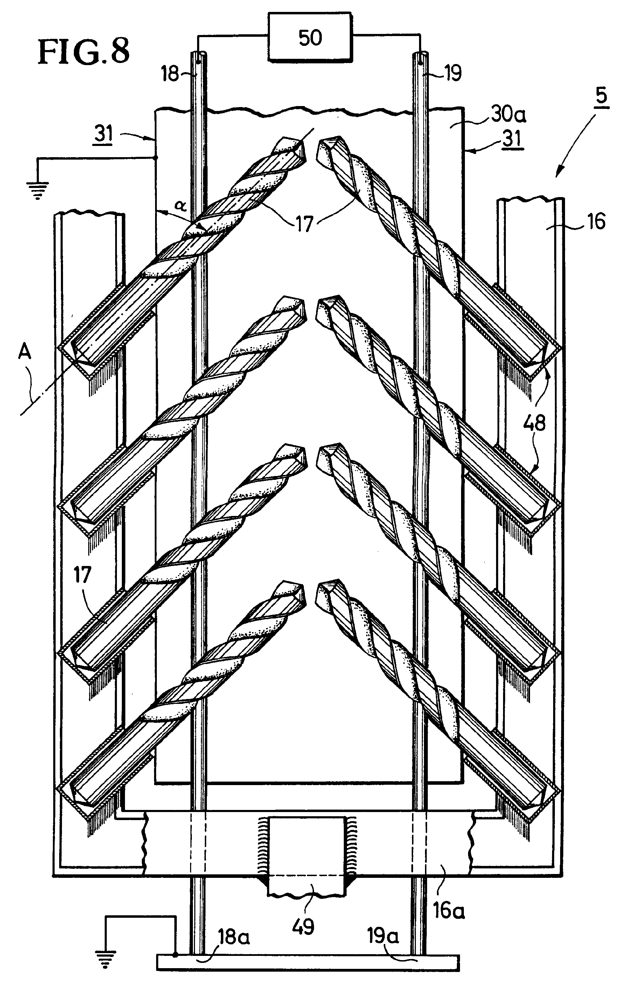

Eine entscheidende Rolle spielt hierbei auch das Verhältnis der Zwischenräume zwischen den Substraten und den Projektionsflächen der Substrate auf eine durch die Zwischenräume hindurchgeführte Projektionsebene. Zum Verständnis dieses Sachverhalts wird auf die Figur 8 verwiesen: Dort kann die Zeichenebene als Projektionsebene angesehen werden. Einerseits ist der Betreiber eines solchen Verfahrens natürlich daran interessiert, innerhalb einer gegebenen Fläche, die durch den Umriß des Targets bestimmt wird, möglichst viele Substrate unterzubringen, andererseits muß er natürlich darauf achten, daß die Gesamtanordnung der Substrate in Querrichtung zu ihrer Ausbreitungsebene eine gewisse "Durchlässigkeit" für den Elektronenstrom erzeugt und im Bereich der Substrate selbst eine hohe Ionisation gewährleistet. Wird der Abstand zwischen den einzelnen Substraten sehr eng und damit das genannte Verhältnis zu gering, so sind diese Forderungen nur noch bedingt zu erfüllen. Insbesondere ist eine allseitige Oberflächenätzung dann nur noch unter Ausführung von Rotationsbewegungen der einzelnen Substrate möglich.

Auf den Elektronenstrom und auf die Ionisierung hat natürlich wiederum die Potentialdifferenz zwischen dem Emitter und der Anode einen entscheidenden Einfluß, d. h. die Substratanordnung einerseits und die genannte Potentialdifferenz andererseits müssen sorgfältig aufeinander abgestimmt werden.

Bei Einhaltung der erfindungsgemäßen Verfahrensparameter, sowie bestimmter geometrischer Verhältnisse, die ihrerseits wieder zu Verfahrensparametern führen, kann erfindungsgemäß ein Ätzprozess aufrechterhalten werden, der zu einer Ätzrate führt, die um Faktor 3 bis 10 größer ist als die Ätzrate beim Stande der Technik. Durch den hohen Leistungseintrag lassen sich auch die Substrate auf einer ausreichend hohen Temperatur halten bzw. bringen. Trotz hoher Ätzrate bzw. hoher Leistung tritt praktisch keine Schädigung von Kanten oder anderen hervorstehenden Oberflächenelementen auf, sodaß bei Anwendung des erfindungsgemäßen Ätzverfahrens für Schneidwerkzeuge deren Schneideigenschaften durch den Ätzprozess nicht verschlechtert werden. Durch die relativ kurze Ätzdauer wird die Wirtschaftlichkeit des Verfahrens beträchtlich erhöht. Insbesondere lassen sich komplizierte Substratgeometrien gleichmäßig ätzen: Der Grund von Spannuten, beispielsweise an Bohrern oder Fräsern läßt sich ebenso sauber ätzen wie andere Oberflächenteile. Dies führt zu einer besseren Haftfestigkeit der nachfolgend während der Beschichtungsphase aufgebrachten harten Schichten.

Das erfindungsgemäße Verfahren wird bevorzugt in einer Ätzatmosphäre von reinem Edelgas, beispielsweise von Argon mit einer Reinheit von 99,99 % durchgeführt, jedoch ist es bei bestimmten Werkstoffen auch mit Vorteil möglich, den Anteil des Edelgases auf 80 % anzusenken und zur Unterstützung des Ätzprozesses mindestens ein Gas aus der Gruppe Wasserstoff, Stickstoff, Ammoniak und Sauerstoff hinzuzufügen.

Die Leistungsdichte wird dabei zwischen 1 und 10 Watt pro $cm^2$ Substratoberfläche gewählt . Die Feldstärke des Magnetfeldes im Substratbereich wird in besonders vorteilhafter Weise zwischen 400 und 2000 A/m gewählt, wobei die angegebene Magnetfeldstärke stets den Gesamtvektor darstellt.

Die Feldstärke des Magnetfeldes am Elektronen-Emitter wird bevorzugt zwischen 2000 und 5000 A/m gewählt, wobei auf jeden Fall aber dafür Sorge zu tragen ist, daß die magnetische Feldstärke im Substratbereich kleiner ist als im Bereich des Elektronen-Emitters.

Das Anodenpotential wird bevorzugt in einem Bereich zwischen + 20 und + 120 V eingestellt.

Um einen Verdrängungseffekt bezüglich der emittierten Elektronen zu vermeiden, wird der Elektronen-Emitter bevorzugt mittels Wechselstrom beheizt, wobei der eine Fußpunkt des Emitters auf Massepotential gelegt wird. Das Anlegen von Massepotential erstreckt sich in vorteilhafter Weise auch auf eine Hilfselektrode, die auf der den Substraten abgekehrten Seite des Emitters angeordnet ist.

Die Erfindung bezieht sich auch auf eine Vorrichtung zur Durchführung des vorstehend beschriebenen Verfahrens. Eine solche Vorrichtung besitzt in herkömmlicher Weise eine Vakuumkammer, einen Substrathalter und eine Bewegungseinrichtung für den Transport des Substrathalters auf einer vorgegebenen Bewegungsbahn sowie einen Stromanschluß für die Beaufschlagung des Substrathalters mit einem gegenüber Masse negativen Ätzpotential und schließlich mindestens eine Anode für die Abfuhr negativer Ladungen.

Der Transport des Substrathalters kann dabei in kontinuierlichem Durchlauf durch die Ätzstation oder aber auch intermittierend bzw. schrittweise erfolgen und es ist auch möglich, den Substrathalter nur dazu zu verwenden, die Substrate in die Ätzstation hinein und wieder aus dieser heraus zu transportieren. Bei bestimmten Anordnungen kann es zweckmäßig sein, die Substrate während des Ätzens in Umdrehung zu versetzen. Hierauf wird in der Detailbeschreibung noch näher eingegangen werden.

Zur Lösung im wesentlichen der gleichen Aufgabe ist die vorstehend beschriebene Vorrichtung erfindungsgemäß dadurch gekennzeichnet, daß auf der einen Seite der Bewegungsbahn des Substrathalters mindestens ein Elektronen-Emitter und auf der gegenüberliegenden Seite der Bewegungsbahn die mindestens eine Anode angeordnet ist, daß der Abstand "a" des Elektronen-Emitters von der Bewegungsbahn um mindestens den Faktor 1,5 größer ist als der Abstand "b" der Anode von der Bewegungsbahn, und daß auf der der Bewegungsbahn abgekehrten Seite des Elektronen-Emitters ein Magnetsystem angeordnet ist, wobei die räumliche Zuordnung so getroffen ist, daß die Bewegungsbahn des Substrathalters einen Bereich der Feldstärke des Magnetsystem durchläuft, die kleiner als 6000 A/m ist und daß der Elektronen-Emitter in einem Bereich der Feldstärke des Magnetsystems liegt, die größer ist als die Feldstärke im Bereich der Bewegungsbahn aber kleiner oder gleich 12000 A/m.

Es ist dabei besonders vorteilhaft, wenn zwischen dem Magnetsystem und dem Elektronen-Emitter eine Hilfselektrode angeordnet ist, die von den Feldlinien des Magnetsystems in der Weise durchdrungen ist, daß die Feldlinien auf der dem Elektronen-Emitter zugekehrten Seite über der Hilfselektrode einen geschlossenen magnetischen Tunnel bilden.

Es ist weiterhin von Vorteil, wenn von der Bewegungsbahn des Substrathalters aus gesehen, die mindestens eine Anode vor der Wand der Vakuumkammer angeordnet ist und wenn der mindestens eine Elektronen-Emitter mit der Hilfselektrode dem Zentrum der Vakuumkammer zugekehrt ist.

Weitere vorteilhafte Ausgestaltungen des Erfindungsgegenstandes sowie verschiedene alternative Möglichkeiten zur Verwirklichung der Erfindung gehen aus den übrigen Unteransprüchen hervor.

Ausführungsbeispiele des Erfindungsgegenstandes werden nachfolgend anhand der Figuren 1 bis 8 näher erläutert.

Es zeigen

Figur 1 einen Horizontalschnitt durch eine Vakuumanlage mit vertikaler Kammerachse und zwei Stationen zum alternierenden Ätzen und Beschichten von Substraten (der für die Erfindung wesentliche Teil ist durch das strichpunktierte Rechteck hervorgehoben),

Figur 2 den Ausschnitt innerhalb des strichpunktierten Rechtecks in Figur 1 in vergrößertem Maßstab,

Figur 3 eine weitere Ausgestaltung des Gegenstandes nach Figur 2 durch Hinzufügung einer Magnetron-Zerstäubungskatode in der Wand der Vakuumkammer,

Figur 4 eine Variante des Gegenstandes nach Figur 2, bei der die Hilfselektrode mit Magnetsystem durch eine Magnetron-Katode mit einem Target ersetzt wurde,

Figur 5 eine Erweiterung des Gegenstandes nach Figur 4, der durch Hinzufügen einer weiteren Magnetron-Katode analog Figur 3 ergänzt wurde,

Figur 6 eine räumliche Umkehrung des Bauprinzips nach Figur 3, bei der die Hilfselektrode mit Magnetsystem und Elektronen-Emittern in die Wand der Vakuumkammer eingesetzt wurden, während die Quelle S für das Beschichtungsmaterial in das Kammerinnere verlagert wurde,

Figur 7 eine Variante des Gegenstandes nach Figur 6, bei der die Hilfselektrode durch eine Magnetron-Katode mit einem Target ersetzt wurde, und

Figur 8 eine Seitenansicht eines mit Substraten (Bohrern) bestückten Substrathalters.

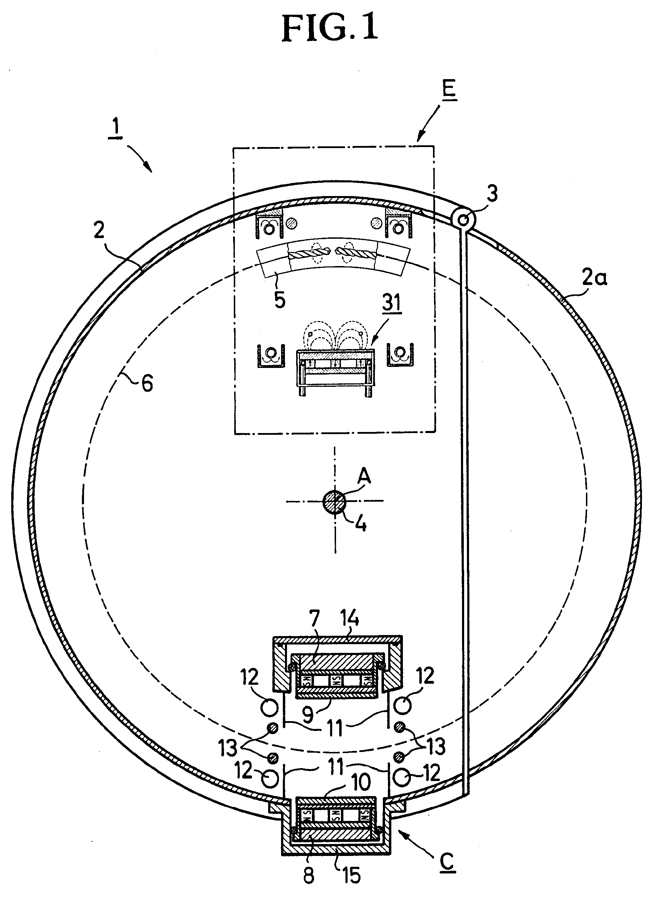

In Figur 1 ist eine Vakuumkammer 1 dargestellt, die eine zylindrische Kammerwand 2 mit senkrechter Achse besitzt. Ein Teil dieser Kammerwand ist segmentförmig abgetrennt und bildet eine Tür 2a, die durch ein Scharnier 3 mit der Vakuumkammer verbunden ist.

Zur Vakuumkammer gehört eine hier nicht näher dargestellte Bewegungseinrichtung mit einer koaxialen Welle 4, durch die ein Substrathalter 5, der in Figur 8 noch näher dargestellt ist, auf einer kreisförmigen Bewegungsbahn 6 geführt werden kann. Die Welle 4 ist in nicht dargestellter Weise isoliert gelagert und mit einem Stromanschluß für die Beaufschlagung des Substrathalters mit einem gegenüber Masse negativen Ätzpotential versehen.

Im Bereich der Bewegungsbahn 6 und im wesentlichen spiegelsymmetrisch zu dieser ist eine Beschichtungsstation C angeordnet, die - für sich genommen - Stand der Technik ist und daher nur kurz erläutert wird. Die Beschichtungsstation C besitzt zwei Magnetron-Katoden 7 und 8 bekannter Bauart mit Targets 9 und 10 aus dem Beschichtungsmaterial. Sofern - wie im vorliegenden Falle - die niedergeschlagenen Schichten aus einer chemischen Verbindung bestehen, beispielsweise aus Titannitrid, dann bestehen die Targets 9 und 10 aus Titan, und sie werden in einer reaktiven Atmosphäre in Gegenwart von Stickstoff zerstäubt. Der zwischen den Targets liegende Reaktionsraum wird auf dem Umfang bis auf einen Durchtrittsspalt für den Substrathalter 5 durch Blenden 11 abgeschirmt. Für die Zufuhr des Reaktionsgases dienen Gasverteilerrohre 12, und das System wird durch Anoden 13 vervollständigt, in die die aus der Entladung hervorgehenden Elektronen eintreten. Die Magnetron-Katode 7 ist unter Zwischenschaltung eines nicht näher bezeichneten Isolierkörpers, der gleichzeitig die Abdichtung bewirkt, in ein Katodengehäuse 14 eingesetzt, das die Magnetron-Katode auch an den Seiten hin unter Belassung eines Spalts umschließt, dessen Breite enger ist als der unter den Betriebsbedingungen gegebene Dunkelraumabstand. In analoger Weise ist auch die Magnetron-Katode 8 in einem Katodengehäuse 15 untergebracht, das vakuumdicht in die Kammerwand 2 eingesetzt ist. Es versteht sich, daß auf dem Umfang der Bewegungsbahn 6 auch mehrere solcher Beschichtungsstationen C angeordnet sein können.

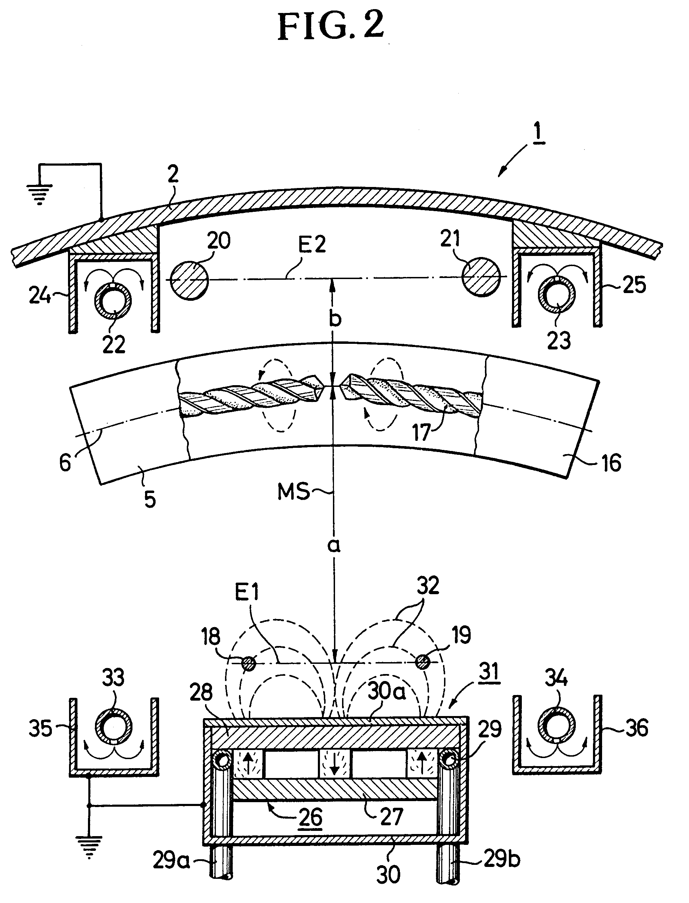

Auf der der Beschichtungsstation C gegenüberliegenden Seite befindet sich die strichpunktiert umrandete Ätzstation E, deren Einzelheiten anhand von Figur 2 unter Zuhilfenahme der Figur 8 näher erläutert werden.

Gemäß Figur 2 bewegt sich der Substrathalter 5 auf seiner Bewegungsbahn 6. Er besitzt einen Rahmen 16, in den gemäß Figur 8 mehrere Substrate 17 eingesetzt sind. Im dargestellten Beispiel handelt es sich um Bohrer, die in fischgrätmusterförmiger Anordnung im Rahmen 16 gehalten sind, wobei die Achsen der Bohrer in etwa tangential zu einer Zylinderfläche verlaufen, in der die Bewegungsbahn 6 liegt. Dadurch ist die etwas gebogene Geometrie der unteren und der oberen Seiten des Rahmens 16 hinreichend definiert.

Auf der einen Seite der Bewegungsbahn 6 des Substrathalters 5 sind in Richtung auf die Achse A der Vakuumkammer 1 zwei Elektronen-Emitter 18 und 19 angeordnet, während auf der gegenüberliegenden Seite der Bewegungsbahn 6 zwei Anoden 20 und 21 angeordnet sind. Die Anordnung ist dabei wie folgt getroffen: Legt man durch die Achsen der Emitter einerseits und der Anoden andererseits zwei untereinander paralelle Ebenen E1 und E2, die in der Zeichnung als strichpunktierte Linien dargestellt sind, und zeichnet man zu den beiden Strecken die gemeinsame Mittelsenkrechte MS, die im übrigen radial zur Achse A (Figur 1) verläuft, so wird diese Mittelsenkrechte MS durch die Bewegungsbahn 6 in eine größere und eine kleinere Strecke unterteilt. Die größere Strecke entspricht dem Abstand a der Elektronen-Emitter von der Bewegungsbahn und ist um mindestens den Faktor 1,5 größer als die andere Strecke, die dem Abstand b der Anoden von der Bewegungsbahn entspricht. Die gesamte Anordnung gemäß Figur 2 ist spiegelsymmetrisch zur Mittelsenkrechten MS aufgebaut.

Die Anoden 20 und 21 sind als zylindrische Stäbe ausgebildet, deren Achsen einen Abstand von 95 mm voneinander und von etwa 20 mm von der Kammerwand 2 haben. Die Länge der Anoden 20 und 21 entspricht dabei mindestens der Höhe des in Figur 8 gezeigten Substrathalters 5. Die Enden der Anoden 20 und 21 sind in der Vakuumkammer 1 isoliert befestigt und an eine Spannungsquelle angeschlossen.

Das Anodenpaar 20/21 ist zwischen Gasverteilerrohren 22 und 23 angeordnet, deren zahlreiche Gas-Austrittsöffnungen zur Kammerwand 2 hin gerichtet sind. Jedes Gasverteilerrohr ist von einem U-förmigen Leitbleich 24 bzw. 25 umgeben, sodaß das eingeleitete Gas bzw. Gasgemisch in Richtung auf die Bewegungsbahn 6 bzw. den Substrathalter 5 umgelenkt wird.

Auf der der Bewegungsbahn 6 abgekehrten Seite der Elektronen-Emitter 18 und 19 befindet sich ein Magnetsystem 26, das aus mehreren Permanentmagneten und einer ferromagnetischen Jochplatte 27 besteht. Die Permanente sind nicht näher beziffert, wohl aber ist ihre entgegengesetzte Pollage durch Pfeile angedeutet. Die freien Polflächen der Permanentmagnete stoßen an eine aus Kupfer bestehende Tragplatte 28 an, auf die eine Kühlmittelleitung 29 mit Anschlüssen 29a und 29b aufgelötet ist. Das gesamte Magnetsystem 26 ist von einem aus Edelstahl bestehenden Gehäuse 30 umgeben und bildet eine sogenannte Hilfselektrode 31, die an Massepotential gelegt ist.

Das Magnetsystem 26 bildet in der Draufsicht (in radialer Richtung) entlang der Mittelsenkrechten MS eine ineinanderliegende Anordnung von Magnetpolen entgegengesetzter Polarität, die einen auf dem Umfang geschlossenen magnetischen Tunnel in Form eines Ovals bzw. einer Rennbahn erzeugen. Dieser magnetische Tunnel ist durch die bogenförmigen gestrichelten Linien angedeutet, die von der Oberfläche der Hilfselektrode 31 ausgehen und zu ihr zurückkehren. Die Elektronen-Emitter 18 und 19 haben in diesem Magnetfeld 32 eine ganz bestimmte räumliche Lage, die durch den Betrag der Feldstärke im Sinne der Lehre der Erfindung definiert wird. Die Feldstärke im Bereich der Substrate 17 ist jedenfalls deutlich geringer.

Auch die Hilfselektrode 31 ist auf beiden Seiten von Gasverteilerrohren 33 und 34 eingerahmt, die ihrerseits wiederum von U-förmigen Leitblechen 35 und 36 umgeben sind, wobei die Anordnung auch in diesem Falle so getroffen ist, daß das Gas bzw. Gasgemisch aus den Gasverteilerrohren 33 und 34 zunächst nach hinten austritt (bezogen auf die Emitter 18 und 19), alsdann jedoch durch die Leitbleche 35 und 36 in Richtung auf die Bewegungsbahn 6 umgelenkt wird.

Wesentlicher Teil der Hilfselektrode 31 ist die den Emittern 18 und 19 zugekehrte Frontplatte 30a des Gehäuses 30. Diese Frontplatte ist jedenfalls zwischen dem Magnetsystem 26 und den Emittern 18 und 19 angeordnet. Das Zentrum der Vakuumkammer wird durch die Welle 4 gebildet, die sich gemäß Figur 1 hinter der Hilfselektrode 31 befindet.

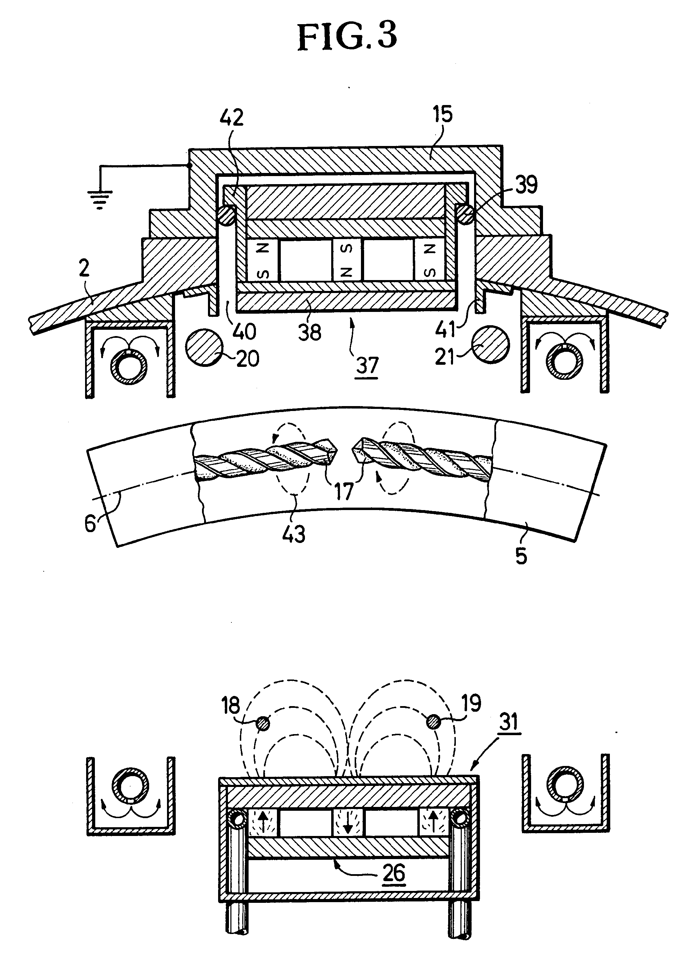

Bei dem Ausführungsbeispiel nach Figur 3 befindet sich auf der Seite der Anoden 20 und 21 in der Wand 2 der Vakuumkammer eine Magnetron-Katode 37 mit einem aus Beschichtungsmaterial bestehenden Target 38. Es handelt sich um ein ganz ähnliches Magnetron, wie es in Figur 1, unten, dargestellt ist.

Die Magnetron-Katode 37 ist durch einen Isolierkörper 39, der gleichzeitig als Dichtungskörper ausgebildet ist, im Katodengehäuse 15 gehalten, und zwar unter Freilassung eines Luftspaltes 40, dessen Weite geringer ist als der sich unter den üblichen Betriebsbedingungen einstellende "Dunkelraumabstand". Für die seitliche Begrenzung des Targets 38 sind an der Kammerwand 2 in gleichem Abstand winkelförmige Erdungsschirme 41 angeordnet. Auf diese Weise wird sichergestellt, daß sich auf dem Umfang des Katodengrundkörpers 42 und des Targets 38 keine Glimmentladung ausbildet.

Die Magnetron-Katode 37 in Figur 3 dient zum Beschichten der Substrate 17 nach Beendigung des Ätzprozesses. Während die Substrate 17 (Bohrer) während des Ätzprozesses nicht gedreht zu werden brauchen, muß wegen der einseitig wirkenden Magnetron-Katode 37 während des Beschichtungsvorganges jedoch eine Rotation der Substrate im Sinne der gestrichelten Pfeile 43 stattfinden.

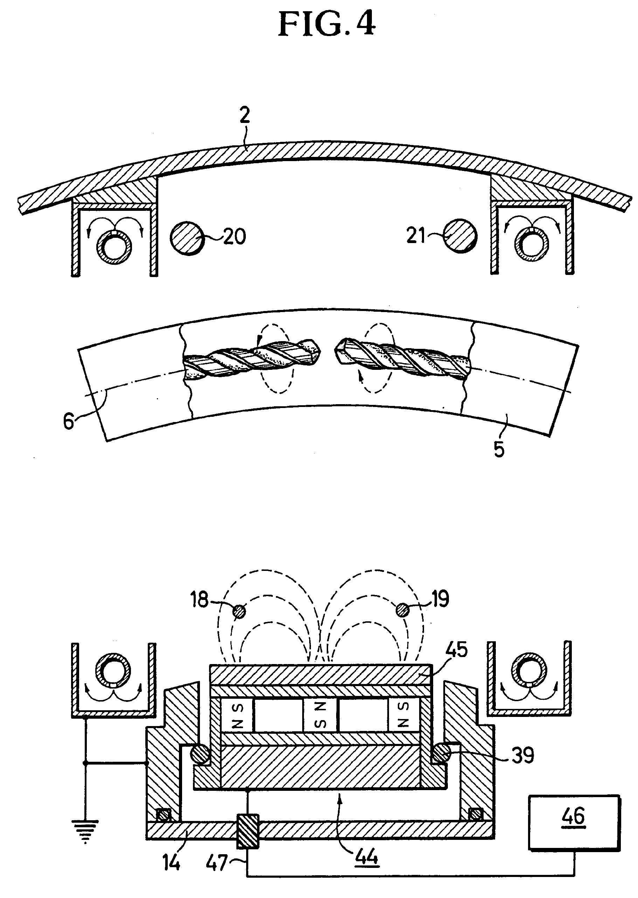

Bei dem Ausführungsbeispiel gemäß Figur 4 ist der obere Teil gegenüber Figur 2 unverändert. An die Stelle der Hilfselektrode 31 mit dem Magtnetsystem 26 ist jedoch eine Magnetron-Katode 44 getreten, und zwar auf der der Bewegungsbahn 6 abgekehrten Seite der Emitter 18 und 19. Auch diese Magnetron-Katode 44 trägt ein aus Beschichtungsmaterial bestehendes Target 45. Die Magnetron-Katode 44 ist im Katodengehäuse 14 gleichfalls mittels eines Isolierkörpers 39 gehalten und über eine Leitung 47 mit einer variablen Spannnungsquelle 46 verbunden. Eine solche Anordnung läßt sich von Ätzen auf Beschichten umschalten. Der Ätzprozeß wird bei einem Katodenpotential von 0 - 300 V durchgeführt. Durch Erhöhen dieses Katodenpoteantials auf etwa 400 - 700 V sowie Erhöhen der Leistungsdichte von 1 Watt/cm$^2$ auf etwa 5 - 20 Watt/cm$^2$ (bezogen auf die Targetoberfläche) läßt sich der Ätzprozeß in einen Beschichtungsprozeß umschalten. Während der Ätzphase bildet das Target 45 gewissermaßen die Hilfselektrode.

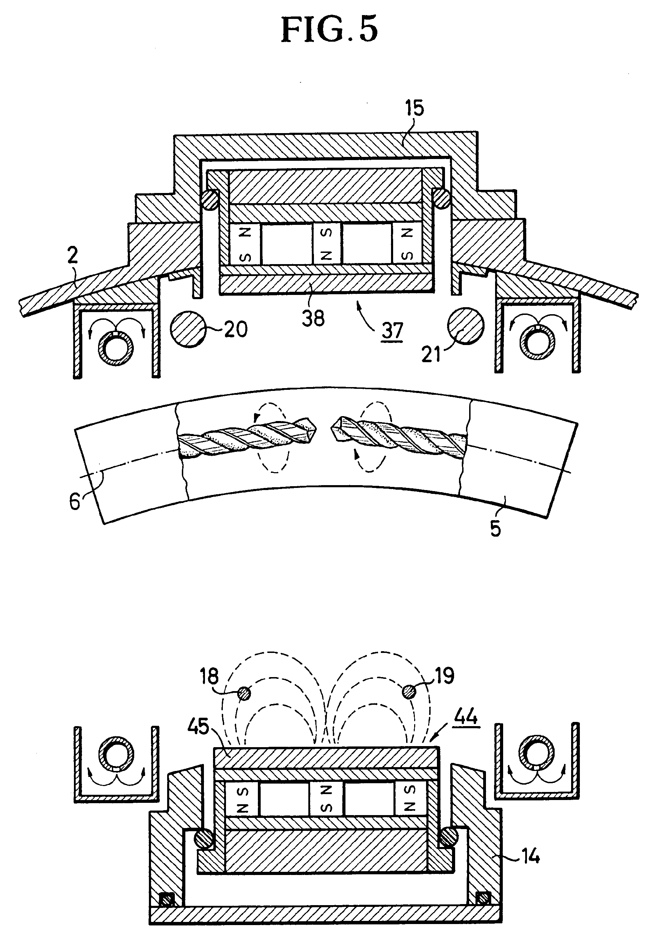

Bei dem Ausführungsbeispiel gemäß Figur 5 sind auf beiden Seiten der Bewegungsbahn 6 in gegenüberliegender Anordnung Magnetron-Katoden 37 (gemäß Figur 3) und 44 (gemäß Figur 4) angeordnet, die mit Targets 38 bzw. 45 versehen sind. Mindestens eine der Magnetron-Katoden ist in analoger Weise wie in Figur 4 an eine variable Spannungsquelle angeschlossen, deren Ausgangsspannung von Ätzbetrieb auf Beschichtungsbetrieb umschaltbar ist. Der Magnetron-Katode 44 sind hier in analoger Weise wie in Figur 4 die beiden Elektronen-Emitter 18 und 19 zugeordnet, während der Magnetron-Katode 37 die Anoden 20 und 21 zugeordnet sind. Die räumliche Lage der Emitter 18 und 19 und der Anoden 20 und 21 relativ zur Bewegungsbahn 6 stimmt im übrigen mit derjenigen in Figur 2 überein, insbesondere im Hinblick auf das Abstandsverhältnis a : b.

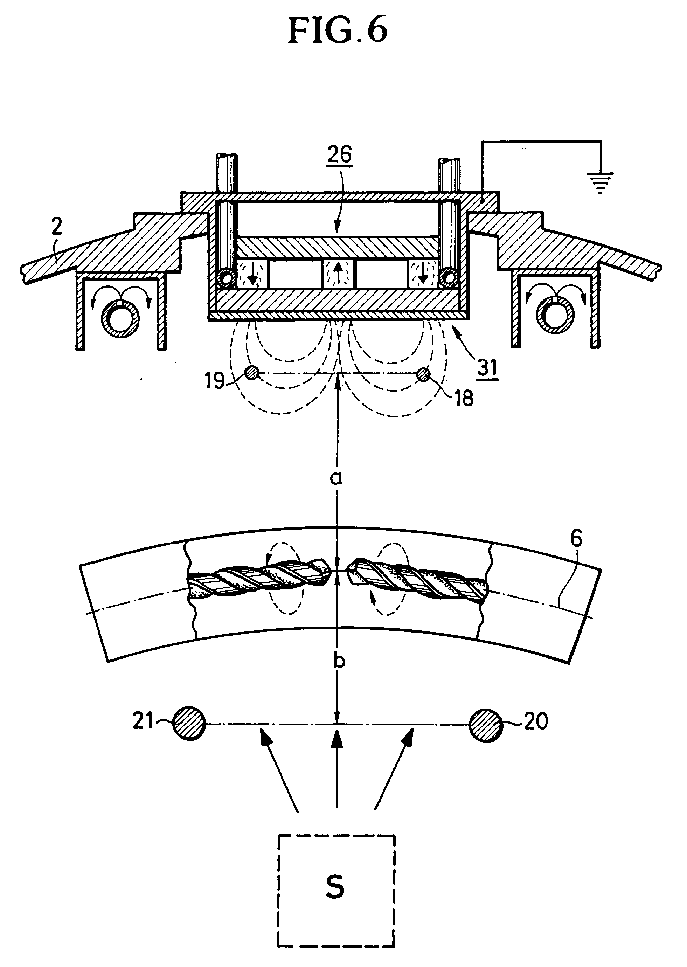

Bei dem Ausführungsbeispiel gemäß Figur 6 ist die räumliche Lage gegenüber derjenigen in Figur 3 im wesentlichen umgekehrt, d. h. die ansonsten völlig übereinstimmende Hilfselektrode 31 mit dem Magnetsystem 26 ist nunmehr in die Kammerwand 2 eingesetzt. Ihr sind - gleichfalls in Übereinstimmung mit Figur 3 - die Emitter 18 und 19 vorgelagert. Auf der den Emittern 18 und 19 gegenüberliegenden Seite der Bewegungsbahn 6 sind nunmehr - in Richtung auf das Zentrum der Vakuumkammer - die beiden Anoden 20 und 21 angeordnet. Die hinter diesen angeordnete Beschichtungsquelle "S" ist nur sehr schematisch dargestellt, sie kann ein Vakuum-Verdampfer sein, eine Ionenquelle oder dergleichen.

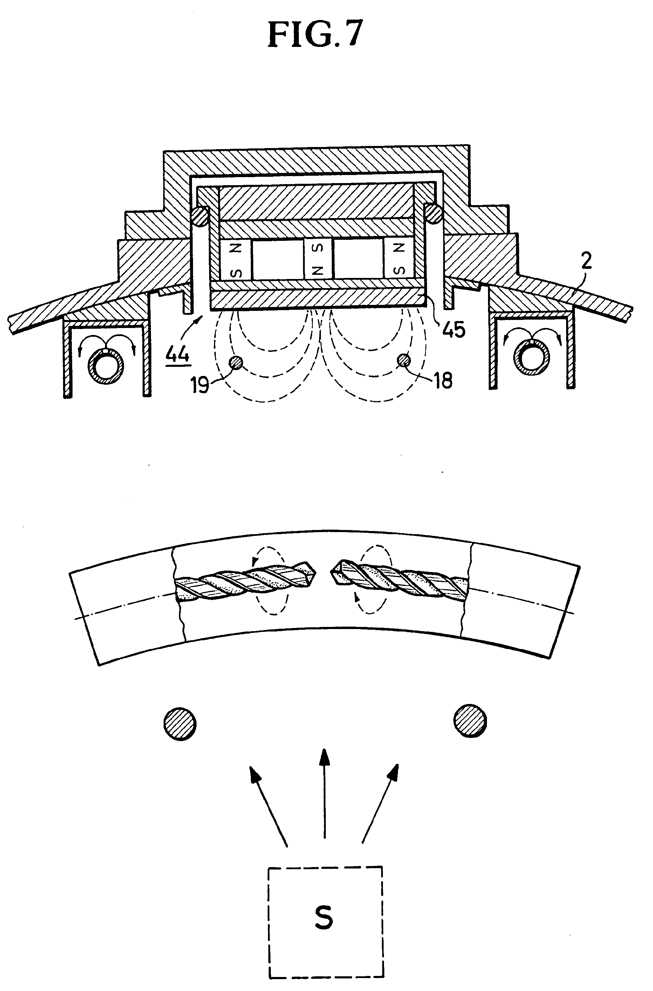

Bei dem Ausführungsbeispiel gemäß Figur 7 sind die Elektronen-Emitter 18 und 19 gleichfalls auf der Seite der Bewegungsbahn 6 angeordnet, die der Kammerwand 2 zugekehrt ist. Von der Bewegungsbahn 6 aus gesehen befindet sich hinter den Emittern 18 und 19 an der Kammerwand 2 eine Magnetron-Katode 44, die mit derjenigen nach Figur 4, unten, übereinstimmt, und die mit einem Target 45 versehen ist. Auch diese Magnetron-Katode ist in nicht näher dargestellter Weise an eine variable Spannungsquelle 46 angeschlossen, wie dies in der genannten Figur 4, unten, dargestellt ist. Durch entsprechende Änderung der Ausgangsspannung der Spannungsquelle 46 läßt sich die Vorrichtung von "Ätzbetrieb" auf "Beschichtungsbetrieb" umschalten.

Figur 8 zeigt den unteren Teil des Rahmens 16 des Substrathalters 5 mit mehreren Einsteckhülsen 48, deren Achsen unter einem Winkel " " zur Senkrechten ausgerichtet sind. Im vorliegenden Fall handelt es sich bei den Substraten 17 um sogenannte Spiralbohrer, die aufgrund der Schrägstellung der Einsteckhülsen 48 nach Art eines Fischgrätmusters ausgerichtet sind. Die untere Rahmenseite 16a ist mit einer Tragstütze 49 versehen, die ihrerseits lösbar in eine Halterung eingesetzt ist, die an der Welle 4 (Figur 1) befestigt ist. Figur 8 zeigt auch die Umrißlinie der Hilfselektrode 31 bzw. die Frontplatte 30a, und sie zeigt auch die beiden Elektronen-Emitter 18 und 19, die sich Form langgestreckter Drähte in vertikaler Richtung vor der Frontplatte 30a und parallel zu dieser erstrecken. Die Fußpunkte 18a und 19a der Emitter sind an Masse gelegt, während die beiden oberen Enden mit einer Stromquelle 50 verbunden sind, sodaß sich die beiden Emitter auf Temperaturen aufheizen lassen, bei denen eine nennenswerte Elektronen-Emission stattfindet.

Sämtliche Targets, Magnetron-Katoden, Hilfselektroden etc haben einen rechteckigen Umriß dessen längste Achse senkrecht verläuft. Auch der geometrisch ähnlich ausgebildete Rahmen 16 des Substrathalters 5 besitzt eine senkrecht ausgerichtete längste Achse, und auch die Emitter 18 und 19 bzw. die Anoden 20 und 21 haben eine solche Länge, daß sie sich durch das gesamte Ätzsystem hindurch erstrecken.

### Beispiel:

In einer Vakuum-Ätz- und -beschichtungsanlage des Typs Z 700 der Firma Leybold Aktiengesellschaft in Hanau, Bundesrepublik Deutschland, die gemäß den Figuren 1, 2 und 8 besonders ausgestattet war, wurden Spiralbohrer mit einem Durchmesser von 8 mm zunächst geätzt und dann mit einem Hartstoffüberzug aus Titan-Aluminium-Nitrid beschichtet.

Die Bohrer waren mit Dichlormethan entfettet und in alkalischen Lösungen gereinigt und abschließend in einem Fluorchlorkohlenwasserstoff getrocknet worden. Die Teile wurden dann in den Substrathalter gemäß Figur 8 eingesetzt. Die Vakuumkammer 1 wurde zunächst bis auf einen Druck von $10^{-5}$ mbar evakuiert, und anschließend wurde Argon mit einem Reinheitsgrad von 99,99% eingelassen, bis der Druck in der Vakuumkammer $2 \times 10^{-2}$ mbar betrug.

Der Achsabstand zwischen den Anoden 20 und 21 betrug 95 mm der Achsabstand zwischen den beiden Emittern 18 und 19 betrug 60 mm. Das Maß a betrug 85 mm, das Maß b 40 mm. Der Abstand der durch die Emitter 18 und 19 hindurch gelegten Ebene E1 von der Frontplatte 30a betrug 20 mm, und die Ebene E1 war von den Polflächen der Permanentmagnete 30 mm entfernt. Die Breite der Hilfselektrode 31 lag bei 80 mm, ihre Länge (in vertikaler Richtung) bei 500 mm.

Das Anodenpotential wurde auf +60 V eingestellt, und an die Substrate wurde eine Spannung von -500 V angelegt. Die Feldstärke des Magnetfeldes im Substratbereich betrug 600 A/m, während die Feldstärke im Bereich der Elektronen-Emitter 3500 A/m betrug. Während des gesamten Ätzbetriebes, der sich über die Dauer von 4 Minuten erstreckte, wurde eine Leistungsdichte von 2 Watt/cm$^2$ Substratoberfläche eingestellt. Es ergab sich eine einwandfreie Ätzung, die sich über die gesamte Oberfläche der Bohrer erstreckte und bei der keine Beschädigung der Schneidkanten erfolgte.

In einem nachfolgenden Beschichtungsprozeß wurden die Bohrer mit einer 4000 nm dicken Schicht aus Titan-Aluminium-Nitrid (TiAlN$_x$) beschichtet. Belastungsversuche ergaben, daß die Titan-Aluminium-Nitridschicht nicht zu Ablösungen neigte.

### Patentansprüche

1.  Verfahren zum Ätzen von Substraten mit einer magnetfeldunterstützten Niederdruck-Entladung, <u>dadurch gekennzeichnet,</u> daß

    a) das Magnetfeld derart von den Substraten entkoppelt ist, daß die magnetische Feldstärke im Substratbereich kleiner als 6000 A/m ist,

    b) in dem Raum zwischen den Substraten und dem Magnetsystem mindestens ein Elektronen-Emitter an einer Stelle angeordnet ist, an der eine magnetische Feldstärke vorhanden ist, die größer ist als die Feldstärke im Bereich der Substrate, aber kleiner oder gleich 12000 A/m,

    c) auf der dem mindestens einen Elektronen-Emitter abgekehrten Seite der Substrate mindestens eine Anode mit einem Anodenpotential von +10 bis +250 V gegenüber Masse angeordnet ist,

    d) an die Substrate ein Ätzpotential zwischen -100 V und -1000 V gegenüber Masse angelegt ist,

    e) das Verhältnis der Zwischenräume zwischen den Substraten und den Projektionsflächen der Substrate auf eine durch die Zwischenräume hindurchgeführte Projektionsebene mindestens 0,1 beträgt,

    f) die Potentialdifferenz zwischen dem mindestens einen Emitter und der mindestens einen Anode so hoch gewählt wird, daß vom Emitter durch die Substratzwischenräume hindurch bis zur Anode ein Elektronenstrom (Primär- und Sekundärelektronen) fließt.

2.  Verfahren nach Anspruch 1, <u>dadurch gekennzeichnet,</u> daß das Ätzen in einer Atmosphäre mit mindestens 80 % eines Edelgases durchgeführt wird.

3. Verfahren nach Anspruch 1, dadurch gekennzeichnet, daß man dem Ätzgas mindestens ein Gas aus der Gruppe Wasserstoff Stickstoff, Ammoniak, Sauerstoff hinzufügt.

4. Verfahren nach Anspruch 1, dadurch gekennzeichnet, daß das Ätzen bei einer Leistungsdichte zwischen 1 und 10 Watt pro Quadratzentimeter Substratoberfläche durchgeführt wird.

5. Verfahren nach Anspruch 1, dadurch gekennzeichnet, daß die Feldstärke des Magnetfeldes im Substratbereich zwischen 400 und 2000 A/m gewählt wird (Gesamtvektor).

6. Verfahren nach Anspruch 1, dadurch gekennzeichnet, daß die Feldstärke des Magnetfeldes am Elektronen-Emitter zwischen 2000 und 5000 A/m gewählt wird.

7. Verfahren nach Anspruch 1, dadurch gekennzeichnet, daß das Anodenpotential zwischen +20 und +120 V eingestellt wird.

8. Verfahren nach Anspruch 1, dadurch gekennzeichnet, daß der mindestens eine Elektronen-Emitter mittels Wechselstrom beheizt und der Fußpunkt auf Massepotential gelegt wird.

9. Verfahren nach Anspruch 1, dadurch gekennzeichnet, daß auf der den Substraten abgekehrten Seite des mindestens einen Emitters eine auf Massepotential gelegte Hilfselektrode angeordnet ist.

10. Verfahren nach Anspruch 1, dadurch gekennzeichnet, daß der Gasdruck der Ätzatmosphäre mindestens $5 \times 10^{-3}$ mbar beträgt.

11. Vorrichtung zur Durchführung des Verfahrens nach Anspruch 1, mit einer Vakuumkammer, mit einem Substrathalter und mit einer Bewegungseinrichtung für den Transport des Substrathalters auf einer vorgegebenen Bewegungsbahn sowie mit einem Stromanschluß für die Beaufschlagung des Substrathalters mit einem gegenüber Masse negativen Ätzpotential und schließlich mit mindestens einer Anode für die Abfuhr negativer Ladungen, dadurch gekennzeichnet, daß auf der einen Seite der Bewegungsbahn (6) des Substrathalters (5) mindestens ein Elektronen-Emitter (18,19) und auf der gegenüberliegenden Seite der Bewegungsbahn die mindestens eine Anode (20,21) angeordnet ist, daß der Abstand "a" des Elektronen-Emitters von der Bewegungsbahn um mindestens den Faktor 1,5 größer ist als der Abstand "b" der Anode (20,21) von der Bewegungsbahn, und daß auf der der Bewegungsbahn (6) abgekehrten Seite des Elektronen-Emitters ein Magnetsystem (26) angeordnet ist, wobei die räumliche Zuordnung so getroffen ist, daß die Bewegungsbahn (6) des Substrathalters einen Bereich der Feldstärke des Magnetsystems durchläuft, die kleiner als 6000 A/m ist und daß der Elektronen-Emitter in einem Bereich der Feldstärke des Magnetsystems liegt, die größer ist als die Feldstärke im Bereich der Bewegungsbahn aber kleiner oder gleich 12.000 A/m.

12. Vorrichtung nach Anspruch 11, dadurch gekennzeichnet, daß zwischen dem Magnetsystem (26) und dem Elektronen-Emitter (18,19) eine Hilfselektrode (31) angeordnet ist, die von den Feldlinien des Magnetsystems in der Weise durchdrungen ist, daß die Feldlinien auf der dem Elektronen-Emitter zugekehrten Seite über der Hilfselektrode einen geschlossenen magnetischen Tunnel bilden.

13. Vorrichtung nach Anspruch 11, dadurch gekennzeichnet, daß von der Bewegungsbahn (6) des Substrathalters (5) aus gesehen, die mindestens eine Anode (20,21) vor der Wand (2) der Vakuumkammer (1) angeordnet ist und daß der mindestens eine Elektronen-Emitter (18,19) mit der Hilfselektrode (31) dem Zentrum der Vakuumkammer zugekehrt ist.

14. Vorrichtung nach Anspruch 13, dadurch gekennzeichnet, daß auf der Seite der mindestens einen Anode (20,21) an der Wand (2) der Vakuumkammer (1) eine Magnetron-Katode (37) mit einem aus Beschichtungsmaterial bestehenden Target (38) angeordnet ist (Figur 3).

15. Vorrichtung nach Anspruch 11, dadurch gekennzeichnet, daß auf der der Bewegungsbahn (6) abgekehrten Seite des mindestens einen Emitters (18,19) eine Magnetron-Katode (44) mit einem aus Beschichtungsmaterial bestehenden Target (45) angeordnet ist, und daß die Magnetron-Katode an eine variable Spannungsquelle angeschlossen ist, deren Ausgangsspannung von "Ätzbetrieb" der Vorrichtung auf "Beschichtungsbetrieb" umschaltbar ist (Figur 4).

16. Vorrichtung nach den Ansprüchen 14 und 15, <u>dadurch gekennzeichnet,</u> daß auf beiden Seiten der Bewegungsbahn (6) in gegenüberliegender Anordnung je eine mit einem aus Beschichtungsmaterial bestehenden Target (38,45) versehene Magnetron-Katode (37,44) angeordnet ist, von denen mindestens eine an eine variable Spannungsquelle angeschlossen ist, deren Ausgangsspannung von "Ätzbetrieb" auf "Beschichtungsbetrieb" umschaltbar ist (Figur 5).

17. Vorrichtung nach den Ansprüchen 11 und 12, <u>dadurch gekennzeichnet,</u> daß der mindestens eine Elektronen-Emitter (18,19) auf der Seite der Bewegungsbahn (6) angeordnet ist, die der Wand (2) der Vakuumkammer (1) zugekehrt ist, daß die Hilfselektrode (31), von der Bewegungsbahn (6) aus gesehen, hinter dem Elektronen-Emitter an der besagten Wand (2) befestigt ist, und daß die mindestens eine Anode (20,21) auf der dem Zentrum der Vakuumkammer zugekehrten Seite der Bewegungsbahn angeordnet ist (Figur 6).

18. Vorrichtung nach den Ansprüchen 11 und 12, <u>dadurch gekennzeichnet,</u> daß der mindestens eine Elektronen-Emitter (18,19) auf der Seite der Bewegungsbahn (6) angeordnet ist, die der Wand (2) der Vakuumkammer zugekehrt ist, und daß - von der Bewegungsbahn (6) aus gesehen - hinter dem Elektronen-Emitter (18,19) an der Wand (2) der Vakuumkammer (1) eine Magnetron- Katode (44) mit einem aus Beschichtungsmaterial bestehenden Target (45) befestigt ist und daß die Magnetron-Katode an eine variable Spannungsquelle angeschlossen ist, deren Ausgangsspannung von "Ätzbetrieb" der Vorrichtung auf "Beschichtungsbetrieb" umschaltbar ist (Figur 7).

## Claims

1. Process for etching substrates with a low-pressure discharge assisted by a magnetic field, characterised in that
   a) the magnetic field is decoupled from the substrates in such a way that the magnetic field-strength in the vicinity of the substrate is less than 6000 A/m,
   b) at least one electron emitter is arranged in the space between the substrates and the magnet system at a point at which a magnetic field-strength is present, which is greater than the field-strength in the vicinity of the substrate, but is less than or equal to 12000 A/m,
   c) at least one anode with an anode potential of +10 to +250 V, with respect to earth, is arranged on the side of the substrate facing away from at least one of the electron emitters,
   d) an etching potential of between -100 V and -1000 V, with respect to earth, is applied to the substrate,
   e) The ratio of the spaces between the substrates, and the projected areas of the substrate on a projection plane passed through the spaces, is at least 0.1,
   f) the potential difference between at least one emitter and at least one anode is of such a value that an electron current (primary and secondary electrons) flows from the emitter through the substrate spaces to the anode.

2. Process according to claim 1, characterised in that etching is carried out in an atmosphere consisting of at least 80% of an inert gas.

3. Process according to claim 1, characterised in that at least one gas from the group: hydrogen, nitrogen, ammonia, oxygen, is added to the etching gas.

4. Process according to claim 1, characterised in that etching is carried out at a power density of between 1 and 10 watts per square centimetre of the substrate surface.

5. Process according to claim 1, characterised in that the field-strength of the magnetic field in the vicinity of the substrate is between 400 and 2000 A/m (total vector).

6. Process according to claim 1, characterised in that the field-strength of the magnetic field at the electron emitter is between 2000 and 5000 A/m.

7. Process according to claim 1, characterised in that the anode potential is set to between +20 and +120 V.

8. Process according to claim 1, characterised in that at least one electron emitter is heated by alternating current and the base is at earth potential.

9. Process according to claim 1, characterised in that an auxiliary electrode at earth potential is positioned at the side of at least one emitter that faces away from the substrates.

10. Process according to claim 1, characterised in that the gas pressure of the etching atmosphere is at least $5 \times 10^{-3}$ mbar.

11. Device for implementing the process according to claim 1, with a vacuum chamber, with a substrate holder and with a motive device for conveying the substrate holder along a specified travel path, and with a power connection for applying a negative etching potential, with respect to earth, to the substrate holder, and finally with at least one anode for draining away negative charges, characterised in that at least one electron emitter (18, 19) is arranged on the one side of the travel path (6) of the substrate holder (5) and at least one anode (20, 21) is arranged on the opposite side of the travel path, that the distance "a" of the electron emitter from the travel path is at least 1.5-times greater than the distance "b" of the anode (20, 21) from the travel path, and that a magnet system (26) is arranged on the side of the electron emitter that faces away from the travel path (6), whereby the spatial relationship is such that the travel path (6) of the substrate holder passes through a field-strength region of the magnet system that is less than 6000 A/m, and that the electron emitter is situated in a field-strength region of the magnet system that is higher than the field-strength in the vicinity of the travel path, but less than or equal to 12000 A/m.

12. Device according to claim 11, characterised in that an auxiliary electrode (31) is arranged between the magnet system (26) and the electron emitter (18, 19) and the lines of force of the magnet system pass through it in such a way that the lines of force on the side facing the electron emitter form a closed magnetic tunnel over the auxiliary electrode.

13. Device according to claim 11, characterised in that, seen from the travel path (6) of the substrate holder (5), at least one anode (20, 21) is arranged in front of the wall (2) of the vacuum chamber (1), and that at least one electron emitter (18, 19) with the auxiliary electrode (31) faces the centre of the vacuum chamber.

14. Device according to claim 13, characterised in that a magnetron cathode (37), with a target (38) consisting of a material coating, is positioned to the side of at least one anode (20, 21) on the wall (2) of the vacuum chamber (1) (Figure 3).

15. Device according to claim 11, characterised in that a magnetron cathode (44), with a target (45) consisting of a material coating, is positioned to the side of at least one emitter (18, 19) facing the travel path (6), and that the magnetron cathode is connected to a variable voltage source whose output voltage can be switched from the device's "etching mode" to the "coating mode" (Figure 4).

16. Device according to claims 14 and 15, characterised in that magnetron cathodes (37, 44), each with a target (38, 45) consisting of a material coating, are positioned opposite each other on either side of the travel path (6), at least one of which being connected to a variable voltage source whose output voltage can be switched from "etching mode" to "coating mode" (Figure 5).

17. Device according to claims 11 and 12, characterised in that at least one electron emitter (18, 19) is positioned at the side of the travel path (6) that faces the wall (2) of the vacuum chamber (1), that, seen from the travel path (6), the auxiliary electrode (31) is attached to the said wall (2) behind the electron emitter, and that at least one anode (20, 21) is arranged on the side of the travel path facing the centre of the vacuum chamber (Figure 6).

18. Device according to claims 11 and 12, characterised in that at least one electron emitter (18, 19) is arranged on the side of the travel path (6) that faces the wall (2) of the vacuum chamber, and that - seen from the travel path (6) - a magnetron cathode (44), with a target (45) consisting of a material coating, is attached to the wall (2) of the vacuum chamber (1) behind the electron emitter (18, 19), and that the magnetron cathode is connected to a variable voltage source whose output voltage can be switched from the device's "etching mode" to the "coating mode" (Figure 7).

**Revendications**

1. Procédé pour décaper des substrats avec une décharge sous basse pression, assistée par champ magnétique, caractérisé par le fait que

a) le champ magnétique est découplé des substrats de manière telle que l'intensité du champ magnétique dans la région des substrats soit inférieure à 6000 A/m,

b) dans l'espace entre les substrats et le système d'aimants est agencé au moins un émetteur d'électrons situé en un endroit où il y a une intensité de champ magnétique plus grande que celle dans la région des substrats mais inférieure ou égale à 12000 A/m,

c) du côté des substrats non en regard dudit émetteur d'électrons au nombre d'au moins un est agencée au moins une anode dont le potentiel par rapport à la masse est de +10 à +250 V,

d) un potentiel de décapage compris entre -100 V et -1000 V par rapport à la masse est appliqué aux substrats,

e) le rapport des espaces intermédiaires entre les substrats et les surfaces de projection des substrats sur un plan de projection passant par les espaces intermédiaires vaut au moins 0,1,

f) la différence de potentiel entre l'émetteur au nombre d'au moins un et l'anode au nombre d'au moins une est choisie pour avoir une valeur telle qu'un courant d'électrons (électrons primaires et secondaires) s'écoule de l'émetteur jusqu'à l'anode en passant par les espaces intermédiaires entre substrats.

2. Procédé selon revendication 1, caractérisé par le fait que le décapage est exécuté dans une atmosphère comportant au moins 80 % d'un gaz rare.

3. Procédé selon revendication 1, caractérisé par le fait que l'on ajoute au gaz de décapage au moins un gaz du groupe hydrogène, azote, ammoniac, oxygène.

4. Procédé selon revendication 1, caractérisé par le fait que le décapage est exécuté avec une densité de puissance comprise entre 1 et 10 watts par centimètre carré de surface de substrat.

5. Procédé selon revendication 1, caractérisé par le fait que l'intensité choisie pour le champ magnétique dans la région des substrats est comprise entre 400 et 2000 A/m (vecteur total).

6. Procédé selon revendication 1, caractérisé par le fait que l'intensité du champ magnétique sur l'émetteur d'électrons est choisie pour être comprise entre 2000 et 5000 A/m.

7. Procédé selon revendication 1, caractérisé par le fait que le potentiel anodique est réglé pour être compris entre +20 et +120 V.

8. Procédé selon revendication 1, caractérisé par le fait que l'émetteur d'électrons au nombre d'au moins un est chauffé par du courant alternatif et sa base est mise au potentiel de masse.

9. Procédé selon revendication 1, caractérisé par le fait qu'une électrode auxiliaire mise au potentiel de masse est agencée en celui des côtés dudit émetteur au nombre d'au moins un qui est éloigné des substrats.

10. Procédé selon revendication 1, caractérisé par le fait que la pression du gaz de l'atmosphère de décapage vaut au moins 5 x 10$^{-3}$ mbar.

11. Dispositif de mise en oeuvre du procédé selon revendication 1, comportant une chambre à vide, un porte-substrats et un dispositif de déplacement pour le transport du porte-substrats sur une trajectoire prédéterminée, ainsi qu'un organe de connexion pour appliquer au porte-substrats un potentiel de décapage négatif par rapport à la masse et enfin au moins une anode pour l'évacuation de charges négatives, caractérisé par le fait qu'au moins un émetteur d'électrons (18, 19) est agencé d'un premier côté de la trajectoire (6) du porte-substrats (5) tandis que, du côté opposé de la trajectoire de déplacement, est agencée l'anode (20, 21) au nombre d'au moins une, par le fait que la distance "a" de l'émetteur d'électrons à la trajectoire de déplacement est, d'au moins un facteur 1,5, plus grande que la distance "b" de l'anode (20, 21) à la trajectoire de déplacement, et par le fait qu'un système d'aimants (26) est agencé en celui des côtés de l'émetteur d'électrons qui n'est pas en regard de la trajectoire de déplacement (6), la disposition géométrique adoptée étant telle que la trajectoire de déplacement (6) du porte-substrats traverse un domaine où l'intensité du champ du système d'aimants est plus petite que 6000 A/m, et par le fait que l'émetteur d'électrons se trouve dans un domaine où l'intensité du champ du système d'aimants est plus grande que l'intensité du champ dans la région de la trajectoire de déplacement mais est inférieure ou égale à 12000 A/m.

12. Dispositif selon revendication 11, caractérisé par le fait qu'entre le système d'aimants (26) et l'émetteur d'électrons (18, 19) est agencée une électrode auxiliaire (31) qui est traversée par les lignes de champ du système d'aimants d'une manière telle qu'un tunnel magnétique fermé soit formé par les lignes de champ, au-delà de l'électrode auxiliaire, du côté tourné vers l'émetteur d'électrons.

13. Dispositif selon revendication 11, caractérisé par le fait qu'en la considérant depuis la trajectoire de déplacement (6) du porte-substrats (5), l'anode (20, 21) au nombre d'au moins une est agencée devant la paroi (2) de la chambre à vide (1) et par le fait que l'émetteur d'électrons (18, 19) au nombre d'au moins un est tourné, avec l'électrode auxiliaire (31), vers le centre de la chambre à vide.

14. Dispositif selon revendication 13, caractérisé par le fait qu'une cathode de magnétron (37) avec une cible (38) faite de matière de revêtement est agencée sur la paroi (2) de la chambre à vide (1), du côté de l'anode au nombre d'au moins une (20, 21) (figure 3).

15. Dispositif selon revendication 11, caractérisé par le fait qu'une cathode de magnétron (44) avec une cible (45) faite de matière de revêtement est agencée en celui des côtés de l'émetteur au nombre d'au moins un (18, 19) qui n'est pas tourné vers la trajectoire de déplacement (6), et par le fait que la cathode de magnétron est raccordée à une source de tension variable, dont la tension de sortie est commutable du mode de marche "décapage" au mode de marche "revêtement" du dispositif (figure 4).

16. Dispositif selon les revendications 14 et 15, caractérisé par le fait qu'il y a, en chacun des deux côtés de la trajectoire de déplacement (6), en agencement opposé, une cathode de magnétron (37, 44) munie d'une cible (38, 45) faite de matière de revêtement, au moins l'une de ces cathodes étant raccordée à une source de tension variable dont la tension de sortie est commutable du mode de fonctionnement "décapage" au mode de fonctionnement "revêtement" (figure 5).

17. Dispositif selon les revendications 11 et 12, caractérisé par le fait que l'émetteur d'électrons (18, 19) au nombre d'au moins un est agencé du côté de la trajectoire de déplacement (6) qui est tourné vers la paroi (2) de la chambre à vide (1), par le fait que, considérée depuis la trajectoire de déplacement (6), l'électrode auxiliaire (31) est fixée à ladite paroi (2), derrière l'émetteur d'électrons, et par le fait que l'anode (20, 21) au nombre d'au moins une est agencée du côté de la trajectoire de déplacement tourné vers le centre de la chambre à vide (figure 6).

18. Dispositif selon les revendications 11 et 12, caractérisé par le fait que l'émetteur d'électrons (18, 19) au nombre d'au moins un est agencé du côté de la trajectoire de déplacement (6) qui est tourné vers la paroi (2) de la chambre à vide, et par le fait qu'une cathode de magnétron (44) avec une cible (45) faite de matière de revêtement est fixée à la paroi (2) de la chambre à vide (1), cela derrière l'émetteur d'électrons (18, 19) en considérant celui-ci depuis la trajectoire de déplacement (6) et par le fait que la cathode de magnétron est raccordée à une source de tension variable dont la tension de sortie est commutable du mode de fonctionnement "décapage" au mode de fonctionnement en "revêtement" du dispositif (figure 7).

# FIG.1

# FIG. 2

EP 0 371 252 B1

# FIG.3

15

# FIG. 4

# FIG.5

# FIG.6

# FIG.7

# FIG.8